# EUROPÄISCHE PATENTANMELDUNG

(11) **EP 2 236 472 A1**
(43) Veröffentlichungstag der Anmeldung: **06.10.2010**
(21) Anmeldenummer: 09014113.6
(22) Anmeldetag: 11.11.2009
(51) Int. Cl.: C03C 17/00, C03C 17/25, H01L 31/052

(54) **Verfahren zum Aufbringen einer porösen Entspiegelungsschicht sowie Glas mit einer Entspiegelungsschicht**

(30) Priorität: 11.11.2008 DE 102008056792
(71) Anmelder: Schott AG, 55122 Mainz (DE)
(72) Erfinder: Henze, Inka, Dr., 55268 Nieder-Olm (DE); Bockmeyer, Matthias, Dr., 55116 Mainz (DE); Römer-Scheuermann, Gabriele, 55218 Mainz (DE); Schmitt, Hans-Joachim, 55437 Ockenheim (DE); Engelmann, Harry, 55218 Ingelheim (DE); Zachmann, Peter, 67574 Osthofen (DE)
(74) Vertreter: Kampfenkel, Klaus

(57) **Zusammenfassung**

Die Erfindung betrifft ein Verfahren zum Aufbringen einer Entspiegelungsschicht, bei welchem Glaspartikel in einer mittels eines Sol-Gel-Verfahrens hergestellten titanoxidhaltigen Matrix eingebettet sind.

## Beschreibung

### Gebiet der Erfindung

Die Erfindung betrifft ein Verfahren zum Aufbringen einer porösen Entspiegelungsschicht sowie ein Glas mit einer Entspiegelungsschicht. Insbesondere betrifft die Erfindung ein entspiegeltes Glas für Solaranwendungen.

### Hintergrund der Erfindung

Entspiegelte Gläser für Solaranwendungen sind bekannt.

Es ist insbesondere bekannt, poröse Entspiegelungsschichten aufzubringen. Ein Verfahren zum Aufbringen poröser Entspiegelungsschichten ist beispielsweise in der deutschen Offenlegungsschrift DE 10 2005 007825 A1 beschrieben. Bei derartigen porösen Entspiegelungsschichten kommt es zu einer Mischung aus dem Beschichtungsmaterial und Luft, wodurch der effektive Brechungsindex der Beschichtung verringert wird.

Die US2007/0017567 A1 beschreibt selbstreinigende Oberflächen u.a. auf Solarmodulen. Die photokatalytisch aktiven Komponenten sind in eine Matrix eingebettet. Die Schichten haben Schichtdicken von 200 nm. In diesen Bereichen sind TiO₂-Schichten optisch auffällig. Schichten zeigen ab 20 nm eine Eigenfarbe (erst gelb dann rot, blau und grün) und ab 5 nm Reflektion im solaren Spektrum. Darüber hinaus ist die Wirkung der photokatalytischen Materialien durch die Einbindung in die Matrix stark eingeschränkt, so dass lediglich die oben aus der Schicht herausragenden Partikel Aktivität zeigen. Die aufgeführten Matrixkomponenten enthalten organische Bestandteile, die durch die Photokatalyse abgebaut werden. Auf den benannten Streuschichten (Albedo-Oberflächen) wird eine in solchen Fällen auftretende Verkreidung möglicherweise nicht auffallen, auf Solarmodulen entstehen durch die Verkreidung jedoch Streuzentren, die Transmission reduzieren.

Es ist ferner bekannt, derartige poröse Entspiegelungsschichten mit einem Sol-Gel-Verfahren aufzubringen.

Die Anforderungen an Entspiegelungsschichten für Solarglas, insbesondere für Fotovoltaik-Anwendungen sind hoch. So soll das Glas eine hohe Transmission möglichst im gesamten Bereich des sichtbaren Lichtes sowie im Nahen Infrarotbereich aufweisen. Die Entspiegelungsschicht sollte daher einen möglichst niedrigen Brechungsindex haben.

Gleichzeitig soll die Entspiegelungsschicht für Jahrzehnte wetterbeständig sein. Auch an die Abriebfestigkeit derartiger Entspiegelungsschichten werden hohe Anforderungen gestellt.

Es hat sich gezeigt, dass herkömmliche poröse Entspiegelungsschichten relativ leicht verschmutzen können, wodurch es zu Einbußen der Transmission kommt. Durch häufiges Reinigen der Entspiegelungsschichten kann es wiederum zu Beschädigungen der Schicht und damit ebenfalls zu einer Verringerung der Transmission kommen.

Für Architekturglas sind Gläser bekannt, welche eine titanoxidhaltige Beschichtung aufweisen. Aufgrund der fotokatalytischen Wirkung von Titanoxid beziehungsweise Titandioxid kommt es zu einem Selbstreinigungseffekt des Glases. Derartige Gläser werden auch als selbstreinigendes Glas bezeichnet.

Aufgrund der hohen Brechzahl von Titanoxid und der damit verbundenen Transmissionseinbußen sind nach herkömmlichen Verfahren hergestellte selbstreinigende Gläser insbesondere für Solaranwendungen nicht gut geeignet, da Leistungseinbuße durch die reflektierende Titanoxidschicht auftreten.

### Aufgabe der Erfindung

Der Erfindung liegt demgegenüber die Aufgabe zugrunde, ein Verfahren bereitzustellen, mit welchem es möglich ist, eine selbstreinigende Entspiegelungsschicht bereitzustellen, welche eine hohe Transmission sicherstellt.

Insbesondere ist es eine Aufgabe der Erfindung, eine selbstreinigende Entspiegelungsschicht mit niedriger Brechzahl bereitzustellen.

Eine weitere Aufgabe der Erfindung ist es, eine umweltbeständige, abriebfeste selbstreinigende Beschichtung bereitzustellen.

### Zusammenfassung der Erfindung

Die Aufgabe der Erfindung wird bereits durch ein Verfahren zum Aufbringen einer porösen Entspiegelungsschicht sowie durch ein Glas für Außenanwendungen, insbesondere für Architektur und Solaranwendungen, nach einem der unabhängigen Ansprüche gelöst.

Glas ist in dieser Erfindung definiert als im Wesentliches transparentes Glas, Glaskeramik oder transparenter, als Scheibe geeigneter Kunststoff, wie beispielsweise Kalknatronglas, Borofloat^{®}, Solargläser und weitere, alle Glaskeramiken, bevorzugt transparente Glaskeramiken, wie Robax^{®}, Zerodur^{®} und weitere, sowie transparente optische Kunststoffe, wie beispielsweise Polymethylmethacrylat, Cycloolefinische Copolymere, Polycarbonat und weitere. Vorzugsweise wird ein Flachglas verwendet, wobei aber die Erfindung nicht auf plattenförmige Substrate beschränkt ist.

Bevorzugte Ausführungsformen und Weiterbildungen der Erfindung sind den jeweiligen Unteransprüchen zu entnehmen.

Die Erfindung betrifft ein Verfahren zum Aufbringen einer porösen Entspiegelungsschicht. Die Entspiegelungsschicht wird mittels eines Sol-Gel-Verfahrens aufgebracht.

Überraschenderweise hat sich gezeigt, dass das Titanoxid keine signifikante Verschlechterung der optischen Eigenschaften einer porösen Entspiegelungsschicht bewirkt.

Vielmehr haben die erfindungsgemäßen Schichten einen vergleichbaren Brechungsindex, wie andere poröse Entspiegelungsschichten, beispielsweise auf Basis von Siliziumoxid-Partikeln und Siliziumoxidmatrix, und somit sehr gute Entspiegelungseigenschaften bei einer zusätzlichen photokatalytisch aktiven Oberfläche.

Gemäß der Erfindung wird ein titanhaltiger Precursor verwendet und es werden der Sol-Gel-Lösung Partikel, insbesondere Nanopartikel, beispielsweise nanopartikuläres Siliziumoxid beziehungsweise Siliziumdioxid hinzugefügt.

Bei dem erfindungsgemäßen Verfahren kommt es durch den titanhaltigen Precursor somit zur Ausbildung einer titanoxidhaltigen Matrix. Vorzugsweise besteht die durch Hydrolyse und Kondensation entstandene Matrix nach einer thermischen Behandlung überwiegend aus amorphen Titanoxid mit einem Restorganikanteil von 10-50%. Über eine thermische Behandlung wird die Restorganik entfernt und es entsteht eine Matrix aus kristallinem bzw. teilkristallinem TiO₂, bevorzugt in der Anatas-Modifikation. Die Kristallitgröße des nanoskaligen kristallinem oder teilkristallinem TiO₂ liegt vorzugsweise zwischen 4 - 35 nm, besonders bevorzugt zwischen 8 - 25 nm. In der Matrix sind Nanopartikel, insbesondere siliziumoxidhaltige Nanopartikel, eingebettet. Das matrixbildende Titanoxid weist dabei vorzugsweise eine Mikro bzw. Mesoporosität von 1 - 25 % auf.

Die erfindungsgemäße Syntheseführung wird dadurch erreicht, dass das matrixbildende TiO₂ sich nur zwischen und/oder auf den SiO₂-Partikeln gebildet hat. Damit wird erreicht, dass die zugängliche Oberfläche an photokatalytisch aktivem TiO₂ groß ist, bei gleichzeitig geringem Massenanteil bzw. Volumenanteil an TiO₂ in der Schicht. Hierdurch wird erreicht, dass trotz der hohen Brechzahl von TiO₂ die Brechzahl des amorph-kristallinen Schichtverbundes niedrig ist.

Es hat sich herausgestellt, dass beispielsweise im Gegensatz zu Verfahren, bei welchen Titandioxid in partikulärer Form, insbesondere in Form von kristallinen Nanopartikeln hinzugefügt wird, sich die optischen Eigenschaften bei nach dem erfindungsgemäßen Verfahren hergestellten Schichten gegenüber einer Beschichtung, welche mit einem siliziumhaltigen Precursor hergestellt wird, nur unwesentlich ändern.

So ist es mit dem erfindungsgemäßen Verfahren gelungen, eine Entspiegelungsschicht mit einer Brechzahl von weniger als 1,38, bevorzugt von weniger als 1,34, und besonders bevorzugt von weniger als 1,30 herzustellen.

Die die Entspiegelungsschicht ist vorzugsweise als Einschicht-Entspiegelungsschicht ausgebildet, die, im Unterschied zu Wechselschicht-Systemen, aufgrund Ihrer Brechzahl eine Entspiegelungswirkung aufweist und bei keiner Wellenlänge die Reflexion des Verbundmaterials erhöht. Die Entspiegelungsschicht ist als Breitband-Entspiegelungsschicht ausgebildet.

Bei einer bevorzugten Ausführungsform der Erfindung haben die Partikel, insbesondere die Nanopartikel, eine Brechzahl kleiner/gleich 1,7, bevorzugt kleiner/gleich 1,6 und besonders bevorzugt kleiner/gleich 1,55.

Hierdurch weist ein mit einer erfindungsgemäßen Entspiegelungsschicht versehenes Glas eine hohe Transmission auf. Insbesondere konnte ein Glas bereitgestellt werden, das im gesamten Wellenlängenbereich zwischen 450 und 800 nm eine Transmission von mindestens 85 %, bevorzugt von mindestens 90 % und besonders bevorzugt von mindestens 95 % aufweist.

Es hat sich ferner herausgestellt, dass bereits ein relativ geringer Anteil an Titanoxid in der gesamten Schicht, insbesondere von weniger als 40, vorzugsweise weniger als 20 und besonders bevorzugt weniger als 15 Gewichts-% ausreichend für einen hinreichenden Selbstreinigungseffekt ist.

Insbesondere wird eine Sol-Gel-Lösung verwendet, bei der das Verhältnis von Partikeln zu Precursor zwischen 0,1 und 0,9, bevorzugt 0,7 und 0,8 liegt, wobei das Verhältnis auf Gewichts-%-Basis berechnet ist.

Insbesondere wird mit der Erfindung ein Glas bereitgestellt, bei welchem die zugesetzten Partikel mindestens 60, vorzugsweise mindestens 70 und besonders bevorzugt mindestens 80 Gewichts-% der fertigen Entspiegelungsschicht einnehmen.

Insbesondere wird mit der Erfindung ein Glas bereitgestellt, bei dem in der erfindungsgemäßen Entspiegelungsschicht eine Porösität (offene Porosität) zwischen 20 und 40 Volumen-% vorliegt. Dadurch, dass die Poren mit Luft gefüllt sind, wird die gewünschte Brechzahl erreicht.

Als besonders geeignet haben sich Nanopartikel in einer Größe zwischen 1 und 100nm, bevorzugt 3 und 70 Nanometer, besonders bevorzugt im Bereich von 6 - 30 nm erwiesen.

Die Partikel sind vorzugsweise aus Glas, Glaskeramik oder Keramik ausgebildet. Mit derartigen Nanopartikeln kann eine hohe Transparenz der Schicht erreicht werden.

In einer Weiterbildung der Erfindung können sich in der Beschichtungslösung verschieden große nanoskalige Partikel, bevorzugt SiO₂-Partikel befinden. Insbesondere ist vorgesehen, Partikel in zumindest zwei verschiedenen Größenfraktionen zuzusetzen. Auch können Siliziumalkoxide der Summenformel Si(OR)₄, RSi(OR)₃ (R= Methyl, Ethyl, Phenyl) ein Bestandteil des Beschichtungslösung sein.

Der Precursor kann beispielsweise ein Titanhalogenid, ein Titannitrat, ein Titansulfat und/oder ein Tetraalkyltitanat (Titantetraalkoxid) umfassen. Insbesondere ist Titantetraethylat und Titantetrapropylat als Precursor vorgesehen.

Um den amorphen Titanhaltigen TiO₂- Precursor in Kombination mit einer wässrigen Dispersion nanokolloiddisperser SiO₂-Partikel stabil in Lösung halten zu können, wird bei einer bevorzugten Ausführungsform der Erfindung eine hydrolysestabilisierten titanhaltigen Vorstufe verwendet.

Bei der erfindungsgemäßen Sol-Synthese wird deshalb zunächst die Titanvorstufe mit einem Komplexliganden umgesetzt. Als Komplexliganden werden z.B. Ethylacetoacetat, 2,4-Pentandion (Acetylaceton), das 3,5-Heptandion, das 4,6-Nonandion oder das 3-Methyl-2,4-pentandion (2-Methylacetylaceton), Triethanolamin, Diethanolamin, Ethanolamin, 1,3-Propandiol, 1,5-Pentandiol, Carbonsäuren wie Essigsäure, Propionsäure, Ethoxyessigsäure, Methoxyessigsäure, Polyethercarbonsäuren (z.B. Ethoxyethoxyessigsäure) Zitronensäure, Milchsäure, Methyl-acrylsäure, Acrylsäure verwendet.

Das molare Verhältnis von Komplexligand zu Titan-Precursor beträgt dabei vorzugsweise 5 - 0,1, bevorzugter 2 - 0,6, besonders bevorzugt 1,2 - 0,8.

Die Partikel sind bezüglich ihrer Partikelgrößenverteilung nicht eingeschränkt. Um eine möglichst gute Partikelverteilung zu erreichen, werden in einer bevorzugten Ausführungsform Partikelmischungen unterschiedlicher Größen eingesetzt. Besonders bevorzugt sind Mischungen, bei denen eine kleinere Partikelverteilung die Lücken einer größeren füllt.

Bei einer bevorzugten Ausführungsform der Erfindung weist die Entspiegelungsschicht Mikroporen oder Mesoporen auf, insbesondere offene Poren mit einem mittleren Porendurchmesser von 1 bis 12 nm, bevorzugt von 3 bis 8 nm. Der Porendurchmesser kann beispielsweise mit der dem Fachmann bekannten Methode der ellipsometrischen Porosimetrie bestimmt werden, wobei H₂O als Sorptiv verwendet wird. Bei dieser Methode wird die Änderung der Brechzahl einer Schicht in Abhängigkeit von der relativen Luftfeuchtigkeit bestimmt. Für die Bestimmung des Porendurchmessers wird dabei die Adsorptionsisotherme verwendet und die Auswertung erfolgt nach einer modifizierten, dem Fachmann bekannten Kelvin-Gleichung. Bevorzugt handelt es sich bei den Poren um stochastische Flaschenhalsporen. In einer besonderen Ausführungsform kann es statt dessen auch um Poren mit einer stäbchenförmigen Geometrie handeln.

Bei einer bevorzugten Ausführungsform der Erfindung enthält der titanhaltige Precursor einen hydrolysestabilisierten, wasserlöslichen, amorphen Titankomplex der Titanhalogenide, Titannitrate, Titansulfate und/oder Tetraalkyltitanat, insbesondere Titantetraethylat und Titanpropylat.

Nach der Umsetzung mit dem Komplexliganden kann, um eine bessere Hydrolysestabilität des Titan-Precursor zu erreichen, noch eine gezielte Hydrolyse durchgeführt werden.

Vorzugsweise sind die Partikel anorganische Materialien, die amorph oder kristallin oder teilkristallin vorliegen.

Die Partikel sind bezüglich ihrer Form nicht eingeschränkt, so können sie beispielsweise rund, plättchenförmig, zylindrisch, faserartig, eckig, kubisch und weitere denkbare Formen haben.

Das molare Verhältnis von Wasser zu Titan-Precursor beträgt dabei 10 - 0,1, bevorzugt 7 - 3, besonders bevorzugt 6 - 4. In einer besonderen Ausführungsform kann die Hydrolyse unter saueren Bedingungen durchgeführt werden. Dazu werden vorzugsweise dem Hydrolysewasser z.B. Mineralsäuren wie HNO₃, HCl, H₂SO₄ oder organische Säuren wie Ethoxyessigsäure, Methoxyessigsäure, Polyethercarbonsäuren (z.B. Ethoxyethoxyessigsäure) Zitronensäure, Paratoluolsulfonsäure, Milchsäure, Methyl-acrylsäure, Acrylsäure zugegeben.

In einer bevorzugten Ausführungsform wird nach Umsetzung des Titan-Precursors mit dem Komplexliganden und anschließender Hydrolyse das Lösungsmittel des Reaktionsgemisches unter vermindertem Druck entfernt. Es wird ein hydrolysestabiles, in polaren (H₂O, Ethanol, n-Propanol) und apolaren (Toluol) Lösungsmitteln wiederlösliches Vorstufenpulver erhalten.

Eine weitere Möglichkeit das Lösungsmittel zu entfernen, um ein wiederlösliches Titanoxid-Vorstufenpulver zu gewinnen, ist das Sprühtrocknen des Reaktionsgemisches.

Die verwendeten amorphen wasserlöslichen Vorstufenpulver können Dotierungen in einer Menge von < 10 mol%, bezogen auf Übergangsmetalloxide , enthalten. Die Dotierung kann vor oder nach der Umsetzung des Titanalkoholats mit der polaren komplexierenden und chelatisierenden Verbindung zugegeben werden. Beispiele für geeignete Dotierungen sind Fe, Mo, Ru, Os, Re, V, Rh, Nd, Pd, Pt, Sn, W, Sb, Ag und Co. Diese können in Form ihrer Salze dem Syntheseansatz bzw. dem Medium in entsprechender Stöchiometrie zugegeben werden.

Bei einer bevorzugten Ausführungsform wird die Sol-Gel-Lösung mit einem Tauchverfahren oder mittels Roll-Coating aufgebracht. Darüber hinaus sind alle weiteren für Flüssigbeschichtungen üblichen Auftragsverfahren einsetzbar, wie beispielsweise Spin-Coating, Sprühen, Schlitzgießen, Fluten und Streichen.

Das Tauchverfahren eignet sich insbesondere für eine gleichmäßige beidseitige Beschichtung großer Glassubstrate.

Das Roll-Coating-Verfahren hat gegenüber dem Tauchverfahren den Vorteil, dass eine Beschichtung in einer Anlage inline ein- oder beidseitig erfolgen kann und keine großen Becken bereitgestellt werden müssen. Darüber hinaus erfolgt die Beschichtung in diesem Fall sehr schnell, so dass hohe Durchsätze möglich sind.

Bei einer bevorzugten Ausführungsform der Erfindung wird die Entspiegelungsschicht bei einer Temperatur zwischen 300 und 1000 °C, vorzugsweise zwischen 450 und 700 °C, besonders bevorzugt zwischen 500 und 700°C eingebrannt beziehungsweise gesintert. Vorzugsweise werden dabei organische Bestandteile, die sich aus dem Sol gebildet haben, weitgehend entfernt.

Die erhaltene Schicht enthält überwiegend Partikel, beispielsweise Siliziumoxidpartikel, die in einer Matrix, die zumindest teilweise aus kristallinem Titanoxid besteht, eingebettet sind.

Der Schritt des Einbrennens kann insbesondere, wie es bei einer weiteren bevorzugten Ausführungsform der Erfindung vorgesehen ist, während eines Vorspann-Prozesses oder einem dem Vorspannprozess direkt vorgelagerten Einbrennen erfolgen.

So ist kein zusätzlicher Arbeitsschritt für das Einbrennen der Entspiegelungsschicht erforderlich und es kann nicht zu einer Verringerung der Vorspannung eines bereits vorgespannten Glases beim nachträglichen Einbrennen einer Entspiegelungsschicht kommen. Es ist dabei von Vorteil, dass die mittels eines Sol-Gel-Verfahrens aufgetragene Schicht bereits eine hinreichende Festigkeit zur nachfolgenden Weiterverarbeitung aufweist.

Dazu ist auch denkbar, die Beschichtung in einem ersten Schritt einer thermischen Härtung bei niedrigerer Tempratur zu unterziehen, wo die Schicht noch nicht auf eine derart hohe Temperatur erwärmt wird, bei der organische Bestandteile zum großen Teil entfernt werden. Hierdurch wird ein zum Vorspannen geeignetes zwischenprodukt mit einer mechanisch beständigen Entspiegelungsschicht geschaffen.

Die Partikel werden vorzugsweise als eine Suspension der Sol-Gel-Beschichtungslösung hinzugegeben.

In einer erfindungsgemäßen Variante werden SiO₂-Partikel über den Stöberprozess hergestellt. Die Partikel können dabei sowohl dicht, mikroporös oder mesoporös sein. Die Morphologie der Partikel kann sowohl sphärischer als auch irregulärer Natur sein.

Zur Steigerung der Abriebbeständigkeit der Schichten, kann in einer besonderen Ausführungsform der Beschichtungslösung auch Aluminium in Form von Alkoxiden, Alumiuniumsalzen, Komplexen der Alkoxide mit Ethylacetat oder AlOOH zugegeben werden. Als Komplexliganden werden z.B. Ethylacetoacetat, 2,4-Pentandion (Acetylaceton), das 3,5-Heptandion, das 4,6-Nonandion oder das 3-Methyl-2,4-pentandion (2-Methylacetylaceton), Triethanolamin, Diethanolamin, Ethanolamin, 1,3-Propandiol, 1,5-Pentandiol, Carbonsäuren wie Essigsäure, Propionsäure, Ethoxyessigsäure, Methoxyessigsäure, Polyethercarbonsäuren (z.B. Ethoxyethoxyessigsäure) Zitronensäure, Milchsäure, Methyl-acrylsäure, Acrylsäure eingesetzt.

Bei einer Weiterbildung der Erfindung können neben den schon genannten silizium- und aluminiumhaltigen Oxiden weitere Halbmetall- oder Metalloxide, wie beispielsweise Boroxid, Zirkonoxid, Ceroxid, sowie Zinkverbindungen Bestandteil der titanhaltigen Matrix sein.

Bei einer Weiterbildung der Erfindung erfolgt die Vereinigung der nanopartikulären Komponente mit dem matrixbildenen Titan-Precursor im sauren Milieu, insbesondere bei einem pH-wert unter 3, bevorzugt unter 2,5, und besonders bevorzugt unter 1,5.

Es hat sich herausgestellt, dass die Kombination von matrixbildenen Titan-Vorstufen und nanokolloiddispersen Nanopartikeln, wie SiO₂-Partikeln nach dem Einbrand zu haft- und abriebfesteren Schichten führt.

Bei einer Weiterbildung der Erfindung wird zwischen dem Substrat und der Entspiegelungsschicht eine Korrosionsschutzschicht, zur Verringerung bzw. Verhinderung der Korrosion des Glases aufgebracht, dass heißt eine Schicht, die den direkten Kontakt von Wasser bzw. H⁺-Ionen mit Alkalien des Substratglases verhindert.

Auf ein Substrat, insbesondere ein Glassubstrat, wird also zunächst eine erste Schicht aufgebracht, auf welche sodann die Entspiegelungsschicht aufgebracht wird.

Es hat sich herausgestellt, dass es durch Wasser in der porösen Entspiegelungsschicht zur Auslaugung, insbesondere von für Architektur und Solaranwendungen verwendeten Kalk-Natron-Gläsern kommt. Die Auslaugung von Alkaliionen, insbesondere von Natrium führt zur Glaskorrosion, welche Eintrübungen des Glases, Zersetzung der Glasmatrix und ein Einbrechen der Entspiegelungsschicht verursacht.

Die Erfinder haben herausgefunden, dass derartige Glaskorrosionsprozesse wirksam durch eine Zwischenschicht verhindert werden können, welche entweder verhindert, dass Wasser mit dem Substratglas in Kontakt kommt oder verhindert, dass Alkaliionen, insbesondere Natriumionen vom Glas in die Entspiegelungsschicht diffundieren.

Durch diese Sperrschicht und die damit verbundenen Unterbindung der Ionendiffusion wird ferner verhindert, dass die photokatalytische Aktivität durch Ionendiffusionsprozesse aus dem Glas in das TiO₂ beeinträchtigt werden kann. Die Korrosionsschutzschicht macht die Kombination einer selbstreinigenden Schicht, basierend auf dem photokatalytischen Effekt von TiO₂, auf Kalk-Natron-Glas möglich.

Die Korrosionsschutzschicht kann beispielsweise als dichte Siliziumoxidschicht aufgebracht werden.

Zum Aufbringen der Korrosionsschutzschicht eignen sich verschiedenste Verfahren, insbesondere kann die Schicht flammpyrolytisch aufgetragen werden oder mittels eines PVD- oder CVD-Verfahrens abgeschieden werden. Auch die Verwendung einer dichten Sol-Gel-Schicht hat sich als brauchbar erwiesen. Besonders vorteilhaft ist hierbei der Einsatz einer dichten Silizium-Titan-Oxid-Mischschicht, die in etwa den gleichen Brechwert wie das Substratglas aufweist. Sie kann beispielsweise dick ausgeführt werden, ohne die optischen Eigenschaften der darüber liegenden Entspiegelungsschicht zu stören. Die Korrosionsschutz- und Barrierewirkung ist deshalb in diesem Fall besonders gut ausgeprägt.

Eine weitere Möglichkeit zur Bereitstellung einer Korrosionsschutzschicht ist das Auslaugen des Substratglases, beispielsweise mittels einer Plasmabehandlung, mittels der Alkali- und/oder Erdalkalibestandteile im Oberflächenbereich mit einer relativ guten Selektivität entfernt werden können.

Eine gute Korrosionsschutzwirkung ist im Sinne der Erfindung dann gegeben, wenn die Diffusion von Alkalien nach dem DIN-Test 52296 oder von Wasser um zumindest 30%, bevorzugt um 50%, besonders bevorzugt 75% reduziert wird.

Die Erfindung betrifft des Weiteren ein Glas, insbesondere für Einsatz im Außenbereich, im Besonderen ein Glas für Solaranwendungen.

Das Glas ist vorzugsweise mit einem erfindungsgemäßen Verfahren hergestellt, umfasst ein Glassubstrat und eine auf dem Glassubstrat mittels eines Sol-Gel-Verfahrens abgeschiedene titanoxidhaltige poröse Entspiegelungsschicht.

Insbesondere umfasst das Glas eine Schicht, bei welcher Partikel, insbesondere Nanopartikel, beispielsweise Siliziumoxidpartikel, in einer Matrix eingebettet sind, die durch einen Sol-Gel-Prozess gebildetes Titanoxid umfasst, insbesondere im Wesentlichen aus Titanoxid besteht.

Vorzugsweise umfasst die Entspiegelungsschicht Siliziumoxidpartikel mit einer Größe zwischen 1 und 100 nm, bevorzugt 3 und 70 Nanometer, besonders bevorzugt im Bereich von 6 - 30 Nanometern.

Vorzugsweise umfassen die Partikel zumindest 50, besonders bevorzugt zumindest 70 Gewichts-% Siliziumoxid. Mit Partikeln, die überwiegend aus Siliziumoxid bestehen, lassen sich niedrige Brechwerte erreichen. Weiter ist Siliziumoxid besonders beständig gegenüber chemischen Angriffen und Umwelteinflüssen.

Als Glassubstrat wird vorzugsweise ein Alkaliglas, insbesondere ein Kalk-Natron-Glas verwendet. Derartige Gläser sind preiswert und besitzen eine hohe Transparenz. In einer besonderen Ausführungsform wird eisenarmes, UVabsorbierendes Solarglas eingesetzt.

Das erfindungsgemäße Glas eignet sich insbesondere in Außenanwendungen als Teil eines Gehäuses für ein Solarmodul, einen Solarreceiver oder als Vorsatzscheibe sowie als Architekturverglasung.

Es hat sich gezeigt, dass unter UV-Strahlungseinwirkung die erfindungsgemäßen Schichten einen selbstreinigenden Effekt zeigen. Dieser selbstreinigende Effekt ist auf die photokatalytische Aktivität des TiO₂ in der Anatas-Modifikation zurückzuführen.

In einer besonderen Ausführungsform der Erfindung ist die photokatalytische Aktivität des TiO₂ schon unter Einstrahlung von Licht im sichtbaren Wellenlängenbereich des Lichtes nachweisbar.

In einer bevorzugten Ausführungsform wird die Entspiegelungsschicht auf ein Glasrohr, das Teil eines Photovoltaikmoduls ist, insbesondere Teil eines CIGSbasierten Photovoltaikmoduls, aufgebracht. Vorzugsweise weist die Entspiegelungschicht auch selbstreinigende Eigenschaften auf. Der Aufbau eines solchen Photovolatikmoduls ist beispielsweise von Innen nach Außen wie folgt ausgestaltet: Im Zentrum befindet sich eine brechwertangepasste Lösung oder Öl (Immersionslösung oder -öl), gefolgt vom Innenrohr aus Glas, dass bevorzugt aus Kalknatronglas oder anderen Natrium enthaltenen Gläsern besteht. Die thermische Dehnung des Innenrohrs ist an die der Absorberschicht, in diesem Fall eine CIGS-Schicht, des solaren Schichtsystems angepasst und liegt zwischen 7,5*10⁻⁶ K⁻¹ und 11*10⁻⁶ K⁻¹, bevorzugt zwischen 8,5*10⁻⁶ K⁻¹ und 10*10⁻⁶ K⁻¹.

Das solare Schichtsystem kann von innen nach außen wie folgt aufgebaut sein: Innenrohr / Barriere (SiN; optional) / Molybdän /Absorberschicht (CIGS)/Pufferschicht (CdS)/Fensterschicht (ZnO). Der gesamte Schichtsaufbau ist bei einem bevorzugten Ausführungsbeispiel zwischen 3 und 4 µm dick. Die äußerste Schicht wird durch die bzw. das oben beschriebene Immersionslösung oder -öl von einem Polymerrohr, bevorzugt Acrylatrohr aufgrund der hohen Transmission getrennt, dass wiederum vom Außenrohr durch die Immersionslösung oder das -öl getrennt ist. Das Außenrohr besteht aus Glas und sollte bevorzugt einen ähnlichen thermischen Ausdehnungskoeffizienten wie das Innenrohr haben. Es ist aber jedes Glas, das eine ausreichend hohe Transmission aufweist denkbar, bevorzugt sind Kalknatron-, Alumosilikat- und Borofloat-Gläser. Die Außenseite des Glasrohres ist mit der selbstreinigenden Antireflexschicht versehen. In einer besonderen Ausführungsform ist unter der selbstreinigenden Antireflexschicht eine Korrosionsbarriereschicht aufgetragen, insbesondere abgeschieden.

In einer weiteren Ausführungsform ist die selbstreinigende Entspiegelungsschicht auf einem planaren CIGS-Photovoltaikmodul aufgebracht.

Die vorzugsweise selbstreinigende Entspiegelungsschicht kann auf jeder Solaranwendung zu Einsatz kommen und ist bezüglich der solaren Absorberschichten und -systeme nicht beschränkt.

Das erfindungsgemäße Glas, insbesondere für Solaranwendungen, umfasst vorzugsweise ein Flachglassubstrat oder ein rohrförmiges Substrat und eine mittels eines Sol-Gel-Verfahrens abgeschiedene titandioxidhaltige poröse Entspiegelungsschicht. Jedoch ist die Erfindung grundsätzliche nicht auf die Form des zu beschichtenden Glassubstrats beschränkt, so dass beliebig geformte Glassubstrate beschichtet werden können.

Um erfindungsgemäße Schichtsysteme herstellen zu können wurde in einem Ausführungsbeispiel folgende allgemeine Syntheseroute verwendet:

Es wurden 110 g Ethanol mit 50 g HNO₃ (1 mol/l) mit X g einer wässrigen Dispersion nanoskaliger SiO₂-Partikel vorgelegt (Die Komponenten X und Y sind in der folgenden Tabelle definiert). Zu dieser Lösung wurden Y g eines amorphen hydrolysestabilisierten Titanoxid-Precursor in 40 g Ethanol gelöst gegeben. Mit den so hergestellten erfindungsgemäßen Beschichtungslösungen können mit einer Zugschwindligkeit von 10-20 cm/min über das Tauchbeschichtungsverfahren, bei einer relativen Feuchte von 30 % und einer Einbrandtemperatur von 450 °C - 700 °C erfindungsgemäße Schichten hergestellt werden.

Amorphe hydrolysestabilisierte Titanoxid-Precursor wurden entsprechend folgender Synthesen hergestellt:

### Precursor A:

Hierzu werden beispielsweise 1,0 mol Titan(IV)-ethylat-Lösung unter Rühren 1,0 mol Acetylaceton innerhalb von etwa 25 Minuten zugetropft, wobei eine deutliche Erwärmung einsetzt. Die zitronengelbe Lösung wird 45 min bei Raumtemperatur gerührt und anschließend mit 5 mol Wasser hydrolysiert. Das Lösungsmittel sowie weitere flüchtige Bestandteile werden im Vakuum bei 80 °C und 40 mbar entfernt. Das Pulver wird anschließend für 4 Std bei 125 °C getrocknet. Man erhält ein feines gelbes Vorstufenpulver mit einem Oxidgehalt von ca. 56 Gew.-%.

### Precursor B:

Hierzu werden beispielsweise 1,0 mol Titan(IV)-propylat-Lösung unter Rühren 1,2 mol Ethoxyessigsäure innerhalb von etwa 25 Minuten zugetropft, wobei deutliche Erwärmung einsetzte. Die zitronengelbe Lösung wird 45 min bei Raumtemperatur gerührt und anschließend mit 5 mol Wasser hydrolysiert. Das Lösungsmittel sowie weitere flüchtige Bestandteile werden im Vakuum bei 80 °C und 40 mbar entfernt. Man erhält ein Gel mit einem Oxidgehalt von ca. 50 Gew.-%.

Die Übersicht über die erfindungsgemäßen Varianten sind in folgender Tabelle dargestellt:

| Solvariante | X (Nanopartikel-Komponente) | Y (Titanoxid-Precursor) |
|---|---|---|
| I | 125 g 30 %ige wässrigen Dispersion von 8 nm großen SiO₂-Partikeln | A - 4,1 g |
| II | 100 g 30 %ige wässrigen Dispersion von 8 nm großen SiO₂-Partikeln 15 g ,50 %ige wässrigen Dispersion von 55 nm großen SiO₂-Partikeln | A - 4,5 g |
| III | 125 g ,30 %ige wässrigen Dispersion von 15 nm großen SiO₂-Partikeln | A - 4,5 g |
| IV | 125 g ,wässrigen Dispersion von 8 nm großen SiO₂-Partikeln | B - 6,1 g |
| V | 125 g ,30 %ige wässrigen Dispersion von 15 nm großen SiO₂-Partikeln | B - 7,3 g |

Die selbstreinigende Wirkung wurde wie folgt geprüft:

Die Untersuchungen wurden u.a. auf Grundlage des DIN-Entwurfes "DIN 52980 Photokatalytische Aktivität von Oberflächen" als Handversuche durchgeführt.

Hierzu werden 3 Lösungen mit unterschiedlichen Konzentrationen an Methylenblau (2x10⁻³ mol/l, 2x10⁻⁴ mol/l, 2x10⁻⁵ mol/l) hergestellt, indem 64 mg, 6,4 mg und 0,64 mg Methylenblau in 100ml H₂O gelöst werden.
Es wurden Tropfen auf die zu messenden Substrate aufgebracht und die Entfärbung durch Bestrahlung in einem Suntest CPS, UV Belastung bis 270 nm, 250-460 W/m² bewertet. Die Ergebnisse des photokatalytisch aktiven Abbaus von 10⁻⁴ mol/l Methylenblau sind in nachfolgender Tabelle 1 dargestellt. Es hat sich gezeigt, dass die erfindungsgemäße Probe gegenüber Referenzsubstraten und auch im Handel verfügbarem photokatalytisch aktivem, selbstreinigendem Glas eine signifikante Verbesserung darstellt.

**Tabelle 1: Entfärbung von 10⁻⁴ mol/l Methylenblau im oben beschriebenen Test.**

| Bestrahlungsdauer [h] | Referenz (unbeschichtet) | Referenz (poröse Einschichtentspiegelung | Käufliches photokat. aktives Architekturglas | Probe IV |
|---|---|---|---|---|
| 0,5 | 5 | 5 | 4 | 4 |
| 1 | 4 | 5 | 3 | 3 |
| 1,5 | 4 | 4 | 3 | 2 |
| 2 | 4 | 4 | 3 | 1 |
| 2,5 | 4 | 4 | 3 | 0 |
| 3 | 3 | 4 | 3 | 0 |
| 3,5 | 3 | 4 | 3 | 0 |
| 4 | 3 | 4 | 3 | 0 |

| | | | | |
|---|---|---|---|---|
| Legende: 0 = keine Rückstände mehr zu erkennen 1 = nur noch sehr schwache Rückstände erkennbar 2 = nur noch schwache Rückstände erkennbar 3 = Rückstände sind noch sichtbar 4 = Rückstände sind noch deutlich sichtbar 5 = keine Veränderung, alle Rückstände sind noch sichtbar | | | | |

### Beschreibung der Zeichnungen

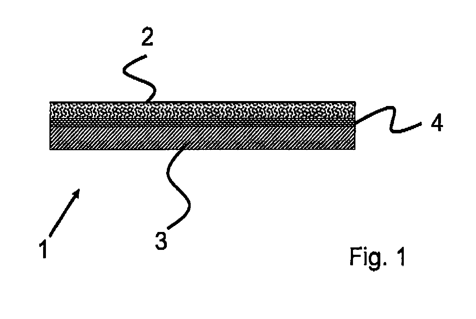

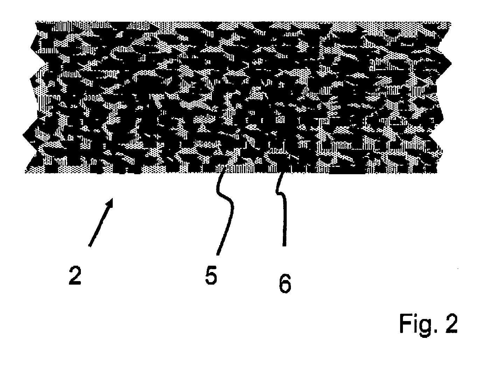

Die Erfindung soll im Folgenden Bezug nehmend auf die Zeichnungen Fig. 1 und Fig. 2 näher erläutert werden.
- Fig. 1: zeigt schematisch dargestellt ein Ausführungsbeispiel eines erfindungsgemäßen Glases,
- Fig. 2: zeigt eine schematische Detailansicht einer Entspiegelungsschicht.

In Fig. 1 ist schematisch ein Glas 1 dargestellt, welches ein Substratglas 3 und eine mittels eines Sol-Gel-Verfahrens aufgebrachte titanoxidhaltige Entspiegelungsschicht 2 umfasst.

Die Entspiegelungsschicht 2 hat in diesem Ausführungsbeispiel einen Anteil an Titandioxid zwischen 5 und 20 % und ist daher aufgrund der fotokatalytischen Wirkung von Titanoxid selbstreinigend. Der Brechungsindex beträgt weniger als 1,34.

Zwischen der Entspiegelungsschicht 2 und dem Substratglas 3 ist in diesem Ausführungsbeispiel eine flammpyrolytisch aufgebrachte dichte Korrosionsschutzschicht 4 angeordnet, welche verhindert, dass Wasser in der porösen Entspiegelungsschicht 2 mit dem Substratglas 3 in Kontakt kommt und so Glaskorrosion im Substratglas 3 verursacht.

Fig. 2 zeigt schematisch dargestellt eine Detailansicht einer Entspiegelungsschicht 2. Die Entspiegelungsschicht 2 umfasst eine mittels eines Sol-Gel-Verfahrens gebildete Matrix 5 aus Titandioxid, in welcher partikuläres Siliziumoxid 6 eingebettet ist.

Die Entspiegelungsschicht kann beispielsweise wie folgt hergestellt werden:

Es werden beispielsweise zu 0,1 mol Titan(IV)-butylat-Lösung unter Rühren 0,1 mol Acetylacetonat getropft. Nach dem folgenden Zutropfen von 0,3 mol H₂O wird die Lösung gerührt (1 h) und 10 g 1,5-Pentandiol beigefügt.

Zu dieser Lösung wird anschließend unter Rühren 48 g einer 30 Gew.-% alkoholischen Dispersion von SiO₂-Nanopartikeln in Isopropanol mit einem mittleren Kugeldurchmesser von 10 bis 15 nm hinzugegeben.

Weiter wird dann unter Rühren 192 g einer 30 Gew.-% alkoholischen Dispersion von SiO₂-Nanopartikeln in Isopropanol mit einem mittleren Kugeldurchmesser von 18 - 30 nm hinzugegeben. Die verwendeten SiO₂-Partikel haben eine im Wesentlichen kugelförmige Geometrie. Anschließend wird die Lösung mit 2400 g Ethanol verdünnt.

Mit der so hergestellten Lösung können mit einer Zuggeschwindigkeit von 10-30 cm/min über das Tauchbeschichtungsverfahren, bei einer relativen Feuchte < 40 % und einer Einbrandtemperatur von 450 - 700 °C mechanisch beständige Entspiegelungsschichten hergestellt werden.

Nach einer weiteren Ausführungsform kann die Entspiegelungsschicht wie folgt hergestellt werden:

Es werden beispielsweise zu 0,1 mol Titan(IV)-butylat-Lösung unter Rühren 0,1 mol Acetylacetonat getropft. Nach dem folgenden Zutropfen von 0,3 mol H₂O wird die Lösung gerührt (1 h) und 10 g 1,5-Pentanediol beigefügt.
Zu dieser Lösung wird anschließend unter Rühren 480 g einer 15 Gew.-% alkoholischen Dispersion von SiO₂-Nanopartikeln in Isopropanol hinzugegeben. Die verwendeten Partikel haben eine längliche, faserartige Geometrie mit einem mittleren Durchmesser von 10 - 15 nm und einer Länge von 30 - 150 nm. Anschließend wird die Lösung mit 2160 g Ethanol verdünnt.

Mit der so hergestellten Lösung können mit einer Zuggeschwindigkeit von 10-30 cm/min über das Tauchbeschichtungsverfahren, bei einer relativen Feuchte < 40 % und einer Einbrandtemperatur von 450 - 700 °C erfindungsgemäße Schichten hergestellt werden.

Mittels der Erfindung konnte ein wetterbeständiges, selbstreinigendes Glas bereitgestellt werden, welches insbesondere für Solaranwendungen geeignet ist.

Es versteht sich, dass die Erfindung nicht auf eine Kombination vorstehend beschriebener Merkmale beschränkt ist, sondern dass der Fachmann sämtliche Merkmale, soweit dies sinnvoll ist, kombinieren wird.

### Bezugszeichenliste

- 1: Glas
- 2: Entspiegelungsschicht
- 3: Substratglas
- 4: Korrosionsschutzschicht
- 5: Titanoxid-Matrix
- 6: Siliziumoxidpartikel

## Patentansprüche

1. Verfahren zum Aufbringen einer porösen Entspiegelungsschicht, wobei die Entspiegelungsschicht mittels eines Sol-Gel-Verfahrens aufgebracht wird, **dadurch gekennzeichnet, dass** ein titanhaltiger Precursor verwendet wird und der Sol-Gel-Lösung Partikel, insbesondere Nanopartikel, zugesetzt werden.

2. Verfahren zum Aufbringen einer Entspiegelungsschicht nach dem vorstehenden Anspruch, **dadurch gekennzeichnet, dass** die Partikel partikuläres Siliziumoxid umfassen.

3. Verfahren zum Aufbringen einer Entspiegelungsschicht nach einem der vorstehenden Ansprüche, **dadurch gekennzeichnet, dass** in der Sol-Gel-Lösung das Verhältnis von Partikeln zu Precursor zwischen 0,1 und 0,9, bevorzugt 0,7 und 0,8 liegt.

4. Verfahren zum Aufbringen einer Entspiegelungsschicht nach einem der vorstehenden Ansprüche, **dadurch gekennzeichnet, dass** die Partikel eine Größe zwischen 1 und 100 nm, bevorzugt 3 und 70 Nanometer, besonders bevorzugt im Bereich von 6 - 30 nm aufweisen.

5. Verfahren zum Aufbringen einer Entspiegelungsschicht nach einem der vorstehenden Ansprüche, **dadurch gekennzeichnet, dass** die Sol-Gel-Schicht bei einer Temperatur zwischen 300 und 1000 °C, vorzugsweise zwischen 450 und 700 °C, besonders bevorzugt zwischen 500 und 700°C eingebrannt wird.

6. Verfahren zum Aufbringen einer Entspiegelungsschicht nach einem der vorstehenden Ansprüche, **dadurch gekennzeichnet, dass** die Entspiegelungsschicht auf ein Glassubstrat aufgebracht wird, wobei das Glassubstrat vorgespannt wird, insbesondere beim Einbrennen der Entspiegelungsschicht.

7. Verfahren zum Aufbringen einer Entspiegelungsschicht nach einem der vorstehenden Ansprüche, **dadurch gekennzeichnet, dass** die Partikel als eine Suspension zugegeben werden.

8. Verfahren zum Aufbringen einer Entspiegelungsschicht nach einem der vorstehenden Ansprüche, **dadurch gekennzeichnet, dass** es sich bei dem in der Matrix enthaltenden Titanoxid um nanokristallines photokatalytisch aktives TiO₂ handelt.

9. Verfahren zum Aufbringen einer Entspiegelungsschicht nach einem der vorstehenden Ansprüche, **dadurch gekennzeichnet, dass** zwischen dem Substrat und der Entspiegelungsschicht eine Korrosionschutzschicht, insbesondere gegenüber Wasserangriff aufgebracht wird.

10. Glas, insbesondere für Solaranwendungen und insbesondere hergestellt mit einem Verfahren nach einem der vorstehenden Ansprüche, umfassend ein Glassubstrat und eine auf dem Glassubstrat mittels eines Sol-Gel-Verfahrens abgeschiedene titanoxidhaltige poröse Entspiegelungsschicht.

11. Glas nach dem vorstehenden Anspruch, **dadurch gekennzeichnet, dass** die Schicht zumindest teilweise durch einen Sol-Gel-Prozess gebildetes Titanoxid sowie Nanopartikel, insbesondere Siliziumoxidpartikel, umfasst.

12. Glas nach einem der vorstehenden Ansprüche, **dadurch gekennzeichnet, dass** die Entspiegelungsschicht zwischen 30 und 95, bevorzugt zwischen 70 und 90 Gewichts-% Partikel enthält.

13. Glas nach einem der vorstehenden Ansprüche, **dadurch gekennzeichnet, dass** zwischen Glassubstrat und Entspiegelungsschicht eine Korrosionsschutzschicht angeordnet ist.

14. Glas nach einem der vorstehenden Ansprüche, **dadurch gekennzeichnet, dass** der Anteil an Titanoxid weniger als 40, vorzugsweise weniger als 20 und besonders bevorzugt weniger als 15 Gewichts-% beträgt.

15. Glas nach einem der vorstehenden Ansprüche, **dadurch gekennzeichnet, dass** die Entspiegelungsschicht einen Brechungsindex von weniger als 1,38, bevorzugt von weniger als 1,34, und besonders bevorzugt von weniger als 1,30 aufweist.
